# EUROPEAN PATENT APPLICATION

(11) **EP 2 581 988 A1**
(43) Date of publication of application: **17.04.2013**
(21) Application number: 11464016.2
(22) Date of filing: 13.10.2011
(51) Int. Cl.: H01R 12/72, H01R 12/71, H01R 31/02

(54) **Adaptor and connection system**

(71) Applicant: Continental Automotive GmbH, 30165 Hannover (DE)
(72) Inventor: Fiilesi, Georges, 300446 Timisora (RO)

(57) **Abstract**

The invention comprises an Adaptor (10) for connecting a printed circuit board (PCB) (5) with an electrical device comprising
- at least a first pin-hole assembly (11, 12) for electrically connecting with the PCB (5),
- at least one connector (13) for electrically connecting with the electrical device,
- a first interface unit (1a) for electrically connecting each pin-hole of the at least first pin-hole assembly (11, 12) with the connector (13) so that signals between the PCB (5) and the electrical device are transmittable.

## Description

The invention relates to an adaptor and a connection system.

Automobiles nowadays comprise an increasing number of functions which are primarily controlled electrically. The provided controllers comprise printed circuit boards (PCB) with pin-configurations for connecting interface units or other devices, whose design is adjusted to the car manufacturers' requirements. Hence, a number of PCBs and pin-maps accordingly exist, which require specific and non-repeatable routing activities. As a consequence, the pin-outs for electronic control units (ECU) are bound to pin-configurations of the related PCBs. In electronics a pin-out is a cross-reference between contacts or pins of an electrical connector or electronic component and their function. Performing for each PCB and its connectors a routing activity, i.e. designing and establishing a different electrical connection between each PCB and electrical devices, is time consuming. The whole development process increases in time considerably.

At the same time the technology of the integrated circuits (ICs) progresses and both printed PCBs and ICs are decreasing in size, which requires an adjustment, mechanically and electrically, of the applied interface units and connections.

From US 6, 430, 057 B1 it is known that PCBs require a redesign due to new generations of ICs which are to be mounted onto the PCBs. For this task adaptor systems have been implemented to match the structural configurations of the new IC Chip with the structural configuration of the PCB. Those adaptor systems require that the IC Chips are similar or identical in their electrical operation characteristics, which is not always the case. In the US 6, 430, 057 B1 an adaptor system is suggested which provides both a structural and an electrical interface unit between an IC Chip and a PCB.

A problem for automotive applications to overcome is that due to different pin-outs at PCBs of different car manufacturers individual connectors for establishing a connection with other electrical devices are required which fit to the different PCBs.

The object of the invention is to create a simplified connection system which overcomes the problem of having a large diversity of connectivity.

This object is achieved by an adaptor with the features of claim 1, and a connection system with the features of claim 5.

Advantageous embodiments which can be used individually or in combination are the subject matter of the dependent claims.

The Adaptor according to the invention for connecting a printed circuit board (PCB) with an electrical device comprises
- at least a first pin-hole assembly for electrically connecting with the PCB,
- at least one connector for electrically connecting with the electrical device,
- a first interface unit for electrically connecting each pin-hole of the at least first pin-hole assembly with the connector so that signals between the PCB and the electrical device are transmittable.

This has the advantage that one adaptor can be used for connecting with various PCBs because all pin-holes of the adaptor are electrically connected to the connector and only those pin-holes will transmit signals of the PCB or the electrical device which are electrical connected to the PCB and the electrical device.

In a preferred embodiment the first interface unit is constructed such that each pin-hole of the at least first pin-hole assembly can be contacted by the connector individually. This has the advantage that one-to-one connections between the first pin-hole assembly and the connector are established which can be individually enabled.

In another preferred embodiment the adaptor comprises a second pin-hole assembly which is adjusted at an angle to the first pin-hole assembly, which can be 90°, and wherein each pin-hole of the second pin-hole assembly is connected to the connector by the first interface unit so that it is ensured that signals between the PCB and the electrical device are transmittable. This has the advantage that the adaptor can be mounted onto the PCB at a preferred alignment in order to use the available space most effectively.

Another aspect of the invention comprises a connection system comprising
- an adaptor and
- a PCB,
wherein the PCB and the adaptor are electrically connected.

By using such a connection system various PCBs can be contacted with one adaptor.

In a preferred embodiment the connection system comprises a second interface unit for electrically connecting the adaptor and the PCB. Commonly, PCBs comprise a pin-hole configuration which requires an adaptor with pins in order to establish an electrical connection. The current invention comprises an adaptor with a pin-hole assembly. The second interface unit is connecting the pin-hole assembly of the adaptor with a electrical connection at the PCB. The electrical signals of the PCB are transferred by the second interface unit to the adaptor.

In another preferred embodiment the second interface unit comprises a pin-assembly for electrically connecting the PCB and the pin-hole assembly of the adaptor.

The pin-assembly of the second interface unit ensures that the PCB can easily be contacted with the pin-hole assembly of the adaptor.

In another preferred embodiment the second interface unit comprises a body where the pin assembly is mounted on. Using a body for fixing the pins has the advantage of adjusting the pins in a favorable position.

In another preferred embodiment the body comprises an insulating material. By such a material the electrical pins are isolated and cannot electrically interact with each other.

In another preferred embodiment the electrical device comprises a harness connector. A harness connector is commonly used for exchanging signals with the engine control unit.

Further advantages and embodiments of the invention will be explained below on the basis of an exemplary embodiment shown in the drawings.

The figures show the following schematic diagrams:
Figure 1 Second Interface unit;
Figure 2 Basic connection system without adaptor;
Figure 3a Adaptor with two pin-hole assemblies;
Figure 3b Adaptor with a first interface unit;
Figure 4 Connection system with adaptor mounted vertically; and
Figure 5 Connection System with adaptor mounted horizontally.

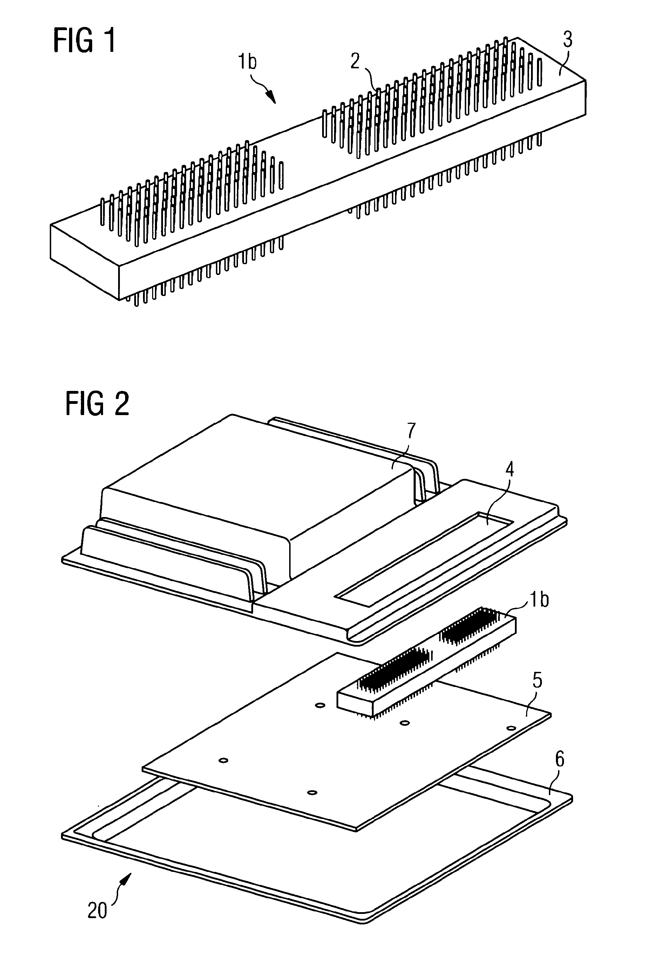

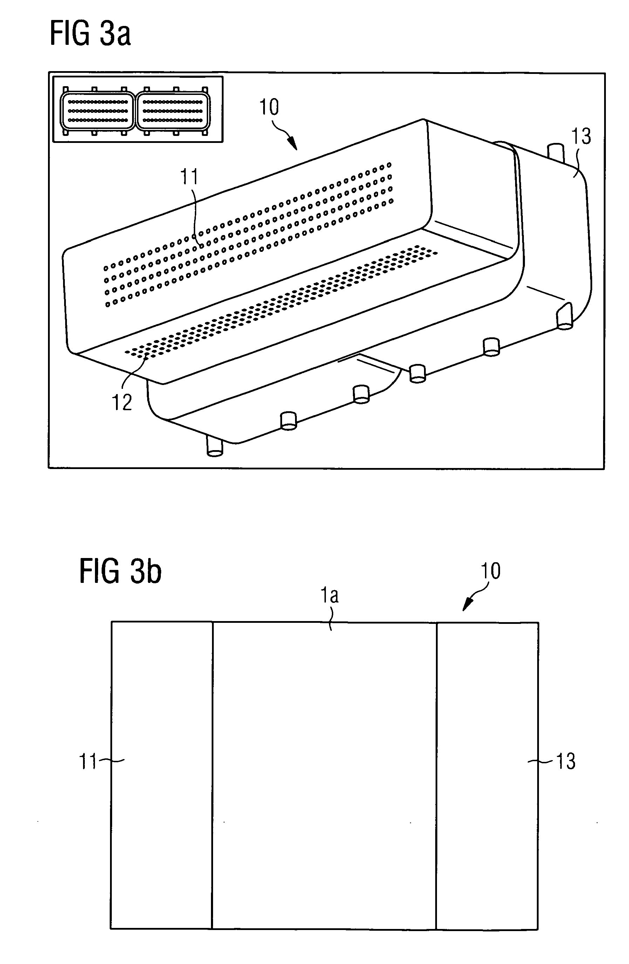

Figure 1 shows a second interface unit 1b comprising a pin-assembly 2. The pin-assembly 2 is mounted on a body 3. The body 3 can comprise an insulating material in order to electrically isolate the pins of the pin-assembly 2. The pin-assembly 2 has a pin-configuration for connecting with an adaptor 10 and a PCB 5 which can comprise a pin-map for electrical contact. The pins used for the pin-assembly 2 can be stitched through the body 3. The pins can also be embedded into the material during its melting state, before solidifying. The second interface unit 1b ensures that the PCB 5 can be connected with a pin-hole assembly 11, 12 as shown in figure 3.

Figure 2 shows a basic connection system 20 without an adaptor 10. It comprises the second interface unit 1b and a PCB 5. The PCB 5 is electrically connected to the pin-assembly 2 of the second interface unit 1b. The basic connection system 20 further comprises a housing 7 and a bottom lid 6. The PCB is arranged within the housing 7 and the bottom lid 6, so that it is protected against mechanical and electrical damages. The housing 7 can comprise a window 4 for contacting the second interface unit 1b from the outside of the housing 7.

Figure 3a shows an adaptor 10. The adaptor 10 comprises a first pin-hole assembly 11, 12 which can be connected with the pin-assembly 2 of the second interface unit 1.

The adaptor 10 comprises at least one connector 13. It is also possible that the adaptor 10 comprises further connectors 13. The connector 13 is for exchanging electrical signals between the PCB 5 via the adaptor 10 and other electrical devices or control units. For transmitting the signals further, e.g. to the engine control unit, a harness connector 14 can be used which is connected to the connector 13.

The adaptor 10 can comprise a second pin-hole assembly 11, 12. The first and second pin-hole assemblies 11, 12 can be adjusted at an angle to each other, e.g. a 90 degree angle.

A first interface unit 1a inside the adaptor 10 can electrically connect each of the pin-holes of each pin-hole assembly 11, 12 to pins or holes to the connector 13 accordingly. Preferably, each of the pin-holes of each pin-hole assembly 11, 12 is individually connected to a single pin or hole of the connector 13 accordingly, so that one-to-one connections are established. In that way it is ensured that the signals which are transmitted between the PCB 5 and the electrical device via one of the pin-hole assemblies 11, 12 can be individually enabled. The first interface unit 1a can also provide a functional connection, so that the electrical connection is dependent on an electrical logic. For example, a connection of a pin-hole of one of the pin-hole assemblies 11, 12 to a pin or hole of the connector 13 can be enabled depending if another connection is enabled or not.

Depending on the configuration of the pin-assembly 2 which is connected to a pin-hole assembly 11, 12 only certain pin-holes are contacted by the second interface unit 1b. On the other side it depends on the electrical device connected to the connector 13 which electrically contacted pin-holes are used for a signal-transmission.

The individual configured PCB 5 and the accordingly matching individual second interface unit 1b are supplying the individual signals to be transmitted. Those signals can be used and processed. Advantageously, only one adaptor 10 is required for connecting any individual PCB 5 to any individual electrical devices.

This is also ensured by a large number of pin-holes of the pin-hole assembly 11, 12. That number has preferably redundancies with regard to known standard pin numbers. In that way it is ensured that at least most of the common PCBs 5 with a second interface unit 1b can be connected to the adaptor 10. Likewise, the connector 13 can have a redundant number of connections so that most of the common electrical devices can be fitted to.

Figure 3b shows an adaptor 10 with a first interface 1a. The first interface unit 1a is assembled in between the first pin-hole assembly 11, 12 and the connector 13 and electrically connects the first pin-hole assembly 11, 12 with the connector 13.

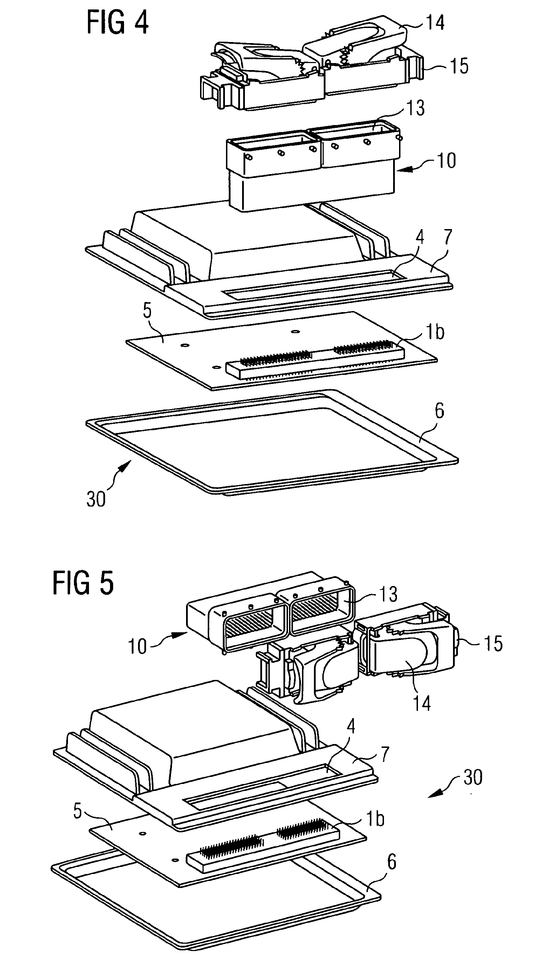

Figure 4 shows a connection system 30 comprising a PCB 5, an adaptor 10 and the second interface unit 1b. The PCB 5 is electrically connected to the pin-assembly 2 of the second interface unit 1b, and one of the pin-hole assemblies 11, 12 of the adaptor 10 is connected also with the pin-assembly 2 of the second interface unit 1b. The connection system 30 also comprises a housing 7 and a bottom lid 6. The PCB is arranged within the housing 7 and the bottom lid 6, so that it is protected against mechanical and electrical damages. The housing 7 can comprise a window 4 for contacting the second interface unit 1b from the outside of the housing 7. It further comprises an adaptor 10 with the connector 13. The connector 13 can be connected with an electrical device directly or with a harness connector 14. In this embodiment the adaptor 10 is mounted vertically according to the connector 13 and the second interface unit 1b.

Figure 5 shows the connection system 30 according to figure 4, but the adaptor 10 is mounted horizontally according to the connector 13 and the second interface unit 1b.

By using an adaptor 10 or a connection system 30 according to the invention a PCB 5 can be directly connected with an adaptor 10, and an electronic device can be connected to the PCB 5 via the adaptor 10. This consequently reduces significantly the layout routing time and hence the development time of such a connection system 30. The described connection system 30 is also known as PCB Connector Interface unit. The connection system 30 is intended to be a proprietary component with a high degree of standardization.

The invention is of particular use for connecting PCBs 5 of automotive applications with a harness connector 14 which is commonly connected with the engine control unit.

## Claims

1. Adaptor (10) for connecting a printed circuit board (PCB) (5) with an electrical device comprising
- at least a first pin-hole assembly (11, 12) for electrically connecting with the PCB (5),
- at least one connector (13) for electrically connecting with the electrical device,
- a first interface unit (1a) for electrically connecting each pin-hole of the at least first pin-hole assembly (11, 12) with the connector (13) so that signals between the PCB (5) and the electrical device are transmittable.

2. Adaptor (10) according to claim 1 wherein the first interface unit (1a) is constructed such that each pin-hole of the at least first pin-hole assembly (11, 12) can be contacted by the connector (13) individually.

3. Adaptor (10) according to claim 1 or 2 comprising a second pin-hole assembly (11, 12) which is adjusted at an angle to the first pin-hole assembly (11, 12) and wherein each pin-hole of the second pin-hole assembly (11, 12) is connected to the connector (13) by the first interface unit (1a) so that signals between the PCB (5) and the electrical device are transmittable.

4. Adaptor (10) according to claim 3 wherein the angle comprises 90°.

5. Connection system (30) comprising
- an adaptor (10) according to claims 1 to 3 and
- a PCB (5),
wherein the PCB (5) and the adaptor (10) are electrically connected.

6. Connection system (30) according to claim 5, comprising a second interface unit (1b) for electrically connecting the adaptor (10) and the PCB (5).

7. Connection system (30) according to claim 6, wherein the second interface unit (1b) comprises a pin-assembly (2) for electrically connecting the PCB (5) and the pin-hole assembly (11, 12) of the adaptor (10).

8. Connection system (30) according to claim 7, wherein the second electrical interface unit (1b) comprises a body (3) where the pin assembly (2) is mounted on.

9. Connection system (30) according to claim 8, wherein the body (3) comprises an insulating material.

10. Connection system (30) according to claims 5 to 9 wherein the electrical device comprises a harness connector (14).
